# EUROPÄISCHE PATENTSCHRIFT

(11) **EP 3 076 193 B1**
(45) Veröffentlichungstag und Bekanntmachung des Hinweises auf die Patenterteilung: **08.05.2024**
(21) Anmeldenummer: 16160631.4
(22) Anmeldetag: 16.03.2016
(51) Int. Cl.: G01R 19/175, G01R 19/00, G01R 35/00

(54) **VORRICHTUNG UND VERFAHREN ZUR MESSUNG EINES STROMES IN EINER LEITUNG IN EINEM BORDNETZ EINES KRAFTFAHRZEUGS**
DEVICE AND METHOD FOR MEASURING A CURRENT IN A CONDUCTOR IN AN ON-BOARD ELECTRICAL NETWORK OF A MOTOR VEHICLE
DISPOSITIF ET PROCEDE DE MESURE DE COURANT DANS UN CONDUCTEUR DANS UN RESEAU ELECTRIQUE EMBARQUE DE VEHICULES MOTORISES

(30) Priorität: 18.03.2015 DE 102015204903
(43) Veröffentlichungstag der Anmeldung: 05.10.2016
(73) Patentinhaber: Volkswagen Aktiengesellschaft, 38440 Wolfsburg (DE)
(72) Erfinder: Haußmann, Heiko, 38118 Braunschweig (DE)
(74) Vertreter: MFG Patentanwälte Meyer-Wildhagen Meggle-Freund Gerhard PartG mbB

(56) Entgegenhaltungen:
- EP-A2- 2 544 365
- DE-A1-102008 043 799
- DE-T5-112012 001 307
- JP-A- 2012 151 969
- US-A- 5 619 137
- US-A1- 2003 095 367
- US-A1- 2014 009 080
- US-A1- 2014 268 473
- US-A1- 2015 054 431
- US-B1- 6 385 056

## Beschreibung

Die Erfindung betrifft ein Kraftfahrzeug-Bordnetz mit einem Strommesser zur Messung eines Stromes in einer Leitung des Bordnetzes und ein Verfahren zur Messung eines Stromes in einer Leitung in einem Bordnetz eines Kraftfahrzeugs.

Es ist bekannt, in einem elektrischen Bordnetz eines Kraftfahrzeugs, den in einer Leitung des Bordnetzes fließenden elektrischen Strom zu messen. Dazu sind unterschiedliche Stromsensoren und Messverfahren bekannt.

Als Stromsensoren sind bspw. sogenannte Shunt-Widerstände bekannt, durch die der zu messende Strom fließt, oder magnetische Stromsensoren (z.B. "Hall-Sensoren", magnetoresistive Sensoren oder dergleichen), die das von dem Strom erzeugte Magnetfeld messen.

Bekannterweise hat bei Sensoren zur Erfassung der Stromstärke die Messgenauigkeit einen hohen Einfluss auf den Preis in dem Sinne, dass je höher die Genauigkeit der Erfassung der Stromstärke ist, desto höher auch der Preis für einen solchen Sensor ist. Zusätzlich kann es vorkommen, dass die physikalische Machbarkeit eine Grenze für eine weitere Erhöhung der Messgenauigkeit darstellt.

In typischen Bordnetzen eines Kraftfahrzeugs, wie in einem Niedervoltbordnetz in dem eine niedrige Spannung (z.B. ca. 14 V) anliegt oder in einem sogenannten Traktionsnetz eines Hybrid- oder Elektrofahrzeugs, in dem eine deutlich höhere Spannung anliegt (z.B. 48 V oder mehr), ist außerdem oftmals eine geringe Nullpunktabweichung bei der Ermittlung der Stromstärke erforderlich. Der Stromverlauf in einer Leitung in einem Bordnetz hat typischerweise im Betrieb des Kraftfahrzeugs einen oder mehrere Nulldurchgänge von "plus nach minus" und umgekehrt, da bspw. beim Bremsen Strom durch das sogenannte Rekuperieren gewonnen wird und sich daher der Stromfluss in der Leitung des Bordnetzes in der der Strom gemessen wird beim Rekuperieren umkehrt, was zu einem Nulldurchgang des Stromverlaufes führt. Die Nullpunktabweichung meint dabei den vom Stromsensor beim Nulldurchgang ermittelten Stromwert, soweit er von Null verschieden ist.

Da in einem Bordnetz eines Kraftfahrzeugs durchaus auch höhere Ströme (z.B. mehrere hundert Ampere) fließen können und daher die Strommessung über einen großen Messbereich erfolgen muss, kann die Nullpunktabweichung selbst bei einer geringen Nullpunktabweichung von bspw. einem Prozent des Stromsensors bereits beträchtlich sein (z.B. +/- 4 A bei einer typischen Stromstärke von 400 A).

Hinzu kommt, dass manche Messverfahren den gemessenen Strom aufsummieren bzw. integrieren. Zum Beispiel ist es bekannt, um den Ladzustand einer Batterie zu bestimmen, den aus der Batterie herausfließenden und den in die Batterie hineinfließenden Strom zu messen und zu integrieren. Der ermittelte Momentanwert des Stroms wird bspw. in einem bestimmten Zeitintervall ermittelt und aufsummiert. Liegt bei dem Stromsensor eine Nullpunktabweichung vor, so addiert sich diese folglich bei solchen Messverfahren auf und der resultierende Ladezustandswert ist fehlerhaft.

Mit anderen Worten, auch kleine Messfehler des Stromsensors am Nulldurchgang können große Fehler im Zeitintegral der Stromstärke erzeugen.

Wie oben erwähnt ist allerdings die einfachste Lösung, nämlich einen Stromsensor mit einer möglichst geringen Nullpunktabweichung zu verwenden, teuer und stößt auch an ihre physikalischen Grenzen.

Zur Bestimmung der Nullpunktabweichung von Stromsensoren ist es im Stand der Technik bekannt, die Batterie eines Bordnetzes von den Verbrauchern zu trennen, indem bspw. Schütze zur Absicherung von Verbrauchern im Bordnetz geöffnet werden. Solange die Batterie von den Verbrauchern durch Öffnen der Schütze getrennt ist, kann der Stromsensor entsprechend justiert werden, da durch die Trennung kein Strom durch den Stromsensor fließt. Der in diesem Zustand vom Stromsensor ermittelte Stromwert kann dann für eine entsprechende Korrektur der Strommesswerte gespeichert werden. Eine Korrektur der Strommessung erfolgt, indem bspw. der gespeicherte Stromwert von einem aktuellen Strommesswert abgezogen wird.

Nachteilig an einem solchen Verfahren ist, dass es nicht immer möglich ist, die Batterie vollständig von den Verbrauchern zu trennen, insbesondere während des Betriebs eines Kraftfahrzeugs. Außerdem kann die Nullpunktabweichung auch von anderen Parametern abhängen, z.B. der Temperatur des Stromsensors. Da sich die Temperatur des Stromsensors während seines Betriebs bzw. des Betriebs des Kraftfahrzeugs verändern kann, kann sich auch die Nullpunktabweichung verändern. Wie erwähnt, ist aber bei dem genannten Verfahren eine (vollständige) Trennung der Batterie von den Verbrauchern nicht möglich, sodass die Nullpunktabweichung nicht während des Betriebs neu bestimmt werden kann und daher sich im laufenden Betrieb die Messfehler aufgrund einer veränderten Nullpunktabweichung des Stromsensors vergrößern können.

Aus der deutschen Offenlegungsschrift DE 10 2008 043 799 A1 ist ein Verfahren zur fehlerkompensierten Strommessung eines elektrischen Akkumulators bekannt. Das Verfahren ermittelt einen Nulldurchgang des Stromes, indem eine auf ein Zeitfenster bezogene geschätzte Ladung bestimmt wird. Außerdem wird der von einem Stromerfassungssensor gelieferte Strommesswert zum Zeitpunkt des Nulldurchgangs ermittelt. Das Verfahren benutzt für die Ladungsschätzung ein Modell, welches Betriebsgrößen (z.B. Akkumulatorklemmspannung, Akkumulatortemperatur oder dergleichen) eines Akkumulators benutzt. Nachteilig daran ist, dass die modellbasierte Schätzung der geflossenen Ladung aufwendig ist und die Genauigkeit unter anderem von der Genauigkeit des verwendeten Modells und von der Genauigkeit der in das Modell einfließenden Betriebsgrößen abhängt.

Die deutsche Offenlegungsschrift DE 11 2012 001307 T5 zeigt eine Leistungsumwandlungsvorrichtung, bei der ein Stromsensor einen durch eine Phasenstromleitung fließenden Phasenstrom erfasst. Eine Erfassungseinheit ermittelt eine Phasenspannung und eine Schätzeinheit schätzt mit einer ersten und zweiten Phasenspannungs-Erfassungseinheit einen Nulldurchgangsstellen-Zeitpunkt.

Aus der amerikanischen Offenlegungsschrift US 2015/0054431 A1 ist ein Steuergerät für einen Dreiphasen AC-Motor bekannt. Das Steuergerät enthält einen Wechselrichter, einen Stromsensor und eine Steuereinheit. Der Wechselrichter treibt den AC-Motor an, der Stromsensor erfasst einen Phasenstrom in einer Phase des AC-Motors und die Steuereinheit schaltet ein Schaltelement des Wechselrichters, um den Stromfluss durch den AC-Motor zu steuern.

Die amerikanische Offenlegungsschrift US 2014/0268473 A1 zeigt einen Stecker zum Koppeln eines Elektrofahrzeugs an eine Stromversorgung, der ein Relay, einen Mikrocontroller und einen Nulldurchgangsdetektor enthält. Das Relay hat Kontakte und kann die Stromversorgung des Elektrofahrzeugs ermöglichen oder verhindern. Der Mikrocontroller gibt ein Kontrollsignal an das Relay aus, um die Stromversorgung zu veranlassen. Der Nulldurchgangsdetektor gibt ein Schließsignal an das Relay aus sobald die Spannung der Stromversorgung im Wesentlichen null ist und gibt ein Öffnungssignal an das Relay aus sobald der Strom der Stromversorgung im Wesentlichen null ist.

Aus der amerikanischen Offenlegungsschrift US 2003/0095367 A1 ist ein elektrisches Energieverteilungssystem bekannt. Ein Schnittstellenmodul ermöglicht die Anbindung an einen Fahrzeugcomputer über einen zweifach redundanten Datenbus, wobei es redundante Mikrocontroller zum Steuern der Stromversorgung einer Vielzahl separater elektrischer Verbraucher enthält und eine Vielzahl an Lastenmanagementmodulen ist vorhanden.

Ein Motorsteuergerät ist aus der europäischen Offenlegungsschrift EP 2 544 365 A2 bekannt.

Die japanische Offenlegungsschrift JP 2012 151 969 A zeigt einen Leistungswandler.

Aufgabe der vorliegenden Erfindung ist es, ein Kraftfahrzeug-Bordnetz mit Strommesser und ein Verfahren zur Strommessung bereitzustellen, welche die oben genannten Nachteile wenigstens teilweise überwinden.

Diese Aufgabe wird durch das erfindungsgemäße Kraftfahrzeug-Bordnetz nach Anspruch 1 und das Verfahren zur Messung eines Stromes nach Anspruch 5 gelöst.

Nach einem ersten Aspekt stellt die vorliegende Erfindung ein Kraftfahrzeug-Bordnetz nach Anspruch 1 bereit. Nach einem zweiten Aspekt stellt die vorliegende Erfindung ein Verfahren nach Anspruch 6 bereit. Weitere Aspekte der Erfindung sind in den abhängigen Ansprüchen, den Zeichnungen und der folgenden Beschreibung ausgeführt.

Weitere vorteilhafte Aspekte der Erfindung ergeben sich aus den Unteransprüchen und der folgenden Beschreibung bevorzugter Ausführungsbeispiele der vorliegenden Erfindung.

Ein erfindungsgemäßes Kraftfahrzeug-Bordnetz mit einem Strommesser zur Messung eines Stromes in einer Leitung des Bordnetz umfasst einen Stromsensor zum Messen eines Stromes in der Leitung des Bordnetzes und zum Ausgeben eines Stromwerts und eine messtechnische Nulldurchgangsschaltung zum Ermitteln eines Nulldurchgangs des Stromes in der Leitung.

Wie eingangs erwähnt, kann es sich bei dem Bordnetz um ein Niedervoltbordnetz, ein Traktionsnetz oder ein anderes elektrischen Netz eines Kraftfahrzeugs handeln. Die vorliegende Erfindung ist weder auf ein bestimmtes Bordnetz noch auf ein bestimmtes Kraftfahrzeug beschränkt. Das Kraftfahrzeug kann ein herkömmliches, rein verbrennungsmotorisch angetriebenes Kraftfahrzeug sein, ein Hybridfahrzeug, ein Elektrofahrzeug oder dergleichen.

Der Stromsensor ist ein Shunt-Widerstand, ein Hall-Sensor oder ein magnetoresistiver Sensor.

Die messtechnische Nulldurchgangsschaltung ermittelt, auch im Gegensatz zur eingangs erwähnten deutschen Offenlegungsschrift DE 10 2008 043 799 A1, den Nulldurchgang des Stromes in der Leitung in dem Bordnetz, in der der Stromsensor den fließenden Strom misst, nicht auf Grundlage eines Modells oder dergleichen, sondern messtechnisch und damit bspw. auch modellunabhängig. Dazu kann die messtechnische Nulldurchgangsschaltung einen Vergleicher oder dergleichen aufweisen, also ein messtechnisches Bauteil, welches direkt einen Nulldurchgang des Stromes mit messtechnischen Mitteln ermittelt.

Durch die Trennung der Messung des Stromes in der Leitung des Bordnetzes und der Ermittlung des Nulldurchgangs des Stromes, kann bspw. der Stromsensor kostengünstig gewählt werden, da er nicht notwendigerweise eine geringe Nullpunktabweichung aufweisen muss. Außerdem kann nun auch während des Betriebs des Strommessers bzw. des Kraftfahrzeugs die Nullpunktabweichung ermittelt werden, sodass auch Veränderungen der Nullpunktabweichung bspw. aufgrund von Temperaturänderungen Rechnung getragen werden kann.

Bei den Ausführungsbeispielen ist der Strommesser dazu eingerichtet, einen zum Zeitpunkt des ermittelten Nulldurchgangs ermittelten Stromwert zu bestimmen, der im Folgenden auch Korrektur-Stromwert genannt wird. Dieser Korrektur-Stromwert, der zum Zeitpunkt des Nulldurchgangs ermittelt wird, dient zum späteren Korrigieren von Strommessungen durch den Stromsensor, indem bspw. der Korrektur-Stromwert von einem aktuellen von dem Stromsensor gemessenen Stromwert abgezogen wird.

Der Strommesser kann weiter einen Stromwertspeicher zum Speichern des zum Zeitpunkt des Nulldurchgangs ermittelten Stromwerts (d.h. des Korrektur-Stromwerts) umfassen, damit er bspw. für die oben genannte spätere Korrektur zu Verfügung steht. Der Stromwertspeicher kann ein Abtast-Halte-Glied aufweisen. Dadurch kann der vom Stromsensor ausgegebene, analoge Stromwert gespeichert werden, ohne dass z.B. eine vorherige Umwandlung in einen digitalen Wert notwendig ist. Bei anderen Ausführungsbeispielen kann der Stromwert auch in digitaler Form gespeichert werden, z.B. an einem Ausgang eines kontinuierlichen Analog-Digital-Wandlers.

Bei manchen Ausführungsbeispielen ist der Strommesser dazu eingerichtet, die vom Strommesser ausgegebenen Stromwerte auf Grundlage des zum Zeitpunkt des ermittelten Nulldurchgangs ermittelten Stromwerts (d.h. des Korrektur-Stromwerts) zu korrigieren. Diese Korrektur kann durch eine entsprechend eingerichtete Schaltung des Strommessers erfolgen oder durch einen entsprechend programmierten Mikroprozessor oder dergleichen. Bei manchen Ausführungsbeispielen werden auch die aktuellen Stromwerte und der Korrektur-Stromwert über eine Schnittstelle an eine zentrale Steuerung, bspw. Batterie-Management-Control ("BMC") übermittelt und die Korrektur wird dort vorgenommen. Bei solchen Ausführungsbeispielen kann der Strommesser folglich auch die Batterie-Management-Control oder die Abschnitte der BMC, die zur Korrektur erforderlich sind, umfassen.

Die messtechnische Nulldurchgangsschaltung weist einen Vergleicher auf, der den Nulldurchgang messtechnisch ermittelt.

Der Vergleicher kann eine definierte Hysterese aufweisen; d.h. der bei einem Wechsel von Plus nach Minus ermittelte Nulldurchgang unterscheidet sich von dem bei einem Wechsel von Minus nach Plus ermittelten Nulldurchgang. Dadurch unterscheiden sich auch die zugehörigen Stromwerte, die bei dem Nulldurchgang von Plus nach Minus und von Minus nach Plus ermittelt werden. Der Korrektur-Stromwert, mit dem dann zukünftige Stromwerte korrigiert werden, kann bspw. durch Mittelung der beiden Stromwerte, die für den Nulldurchgang von Plus nach Minus und von Minus nach Plus ermittelt wurde, bestimmt werden. Die Hysterese ist vorzugsweise symmetrisch, kann aber auch asymmetrisch sein, wobei dann die Asymmetrie bei der Bestimmung des gemittelten Stromwertes entsprechend berücksichtigt werden kann. Bei manchen Ausführungsbeispielen kann der Vergleicher mit definierter Hysterese eine genauere Ermittlung der Nullpunktabweichung erlauben, als ein Vergleicher ohne definierte Hysterese.

Wie erwähnt weist der Stromsensor einen Hall-Sensor, einen Shunt-Widerstand oder einen magnetoresistiven Sensor auf, wobei aufgrund der zur Strommessung parallelen Nulldurchgangsbestimmung die Nullpunktabweichung des Stromsensors auch groß und der Stromsensor damit auch kostengünstig gewählt werden kann. Magnetische Stromsensoren, wie der Hall-Sensor sind typischerweise von einer Batterie des Bordnetzes galvanisch getrennt und benötigen keinen Widerstand für die Strommessung, wodurch sie günstig sein können, da z.B. Widerstände im Strompfad einer Traktionsbatterie aufgrund der hohen fließenden Ströme teuer sind und hohe Verluste verursachen können.

Manche Ausführungsbeispiele betreffen ein Verfahren zur Messung eines Stromes in einer Leitung in einem Bordnetz eines Kraftfahrzeugs. Das Verfahren umfasst die Schritte:
- Messen eines Stromes in der Leitung des Bordnetzes;
- Messen eines Nulldurchgangs des Stromes;
- Ermitteln des bei dem Nulldurchgang gemessenen Stromes; und
- Korrigieren der Strommessung auf Grundlage des bei dem Nulldurchgang gemessenen Stromes.

Das Verfahren kann bspw. computerimplementiert sein und/oder in einer Steuerung, wie bspw. einer Batterie-Management-Control oder dergleichen ablaufen. Außerdem kann es als Programmcode in einer Datei oder einem Datenträger gespeichert sein.

Ausführungsbeispiele der Erfindung werden nun beispielhaft und unter Bezugnahme auf die beigefügte Zeichnung beschrieben, in der:
Fig. 1 schematisch ein erstes Ausführungsbeispiel eines Strommesser mit einem Shunt-Widerstand veranschaulicht;
Fig. 2 schematisch ein zweites Ausführungsbeispiel eines Strommessers mit einem Hall-Sensor veranschaulicht;
Fig. 3 schematisch ein drittes Ausführungsbeispiel eines Strommessers mit einem Vergleicher mit Hysterese veranschaulicht;
Fig. 4 typische Stromverläufe für den realen, den gemessenen, den Offset-Strom und den korrigierten Strom darstellt; und
Fig. 5 ein Ablaufschema eines Ausführungsbeispiels eines Verfahrens zur Messung eines Stromes darstellt.

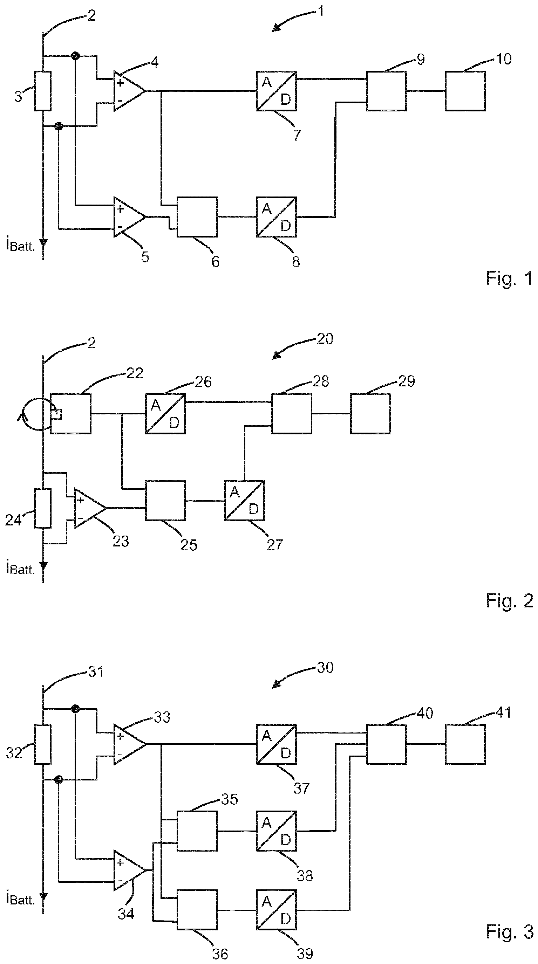

Ein erstes Ausführungsbeispiel eines Strommessers 1 ist in Fig. 1 veranschaulicht. Der Strommesser 1 hat einen Shunt-Widerstand 3, der in einer Leitung 2 eines Bordnetzes eines Kraftfahrzeugs angeordnet ist.

Die beiden Ausgänge des Shunt-Widerstandes 3 sind mit einem jeweiligen Eingang eines Differenzverstärkers 4 gekoppelt. Außerdem sind die beiden Ausgänge des Shunt-Widerstandes 3 parallel mit einem jeweiligen Eingang eines Vergleichers 5 gekoppelt.

Der Ausgang des Differenzverstärkers 4 ist mit dem Eingang eines Analog-Digital-Wandlers 7 gekoppelt und parallel dazu mit einem (analogen) Eingang eines Abtast-Halte-Glieds 6. Außerdem ist der Ausgang des Vergleichers 5 ebenfalls mit einem (digitalen Steuer-)Eingang des Abtast-Halte-Glieds 6 gekoppelt.

Ein Ausgang des Abtast-Halte-Glieds 6 ist mit einem Eingang eines weiteren Analog-Digital-Wandlers 8 gekoppelt.

Der jeweilige Ausgang des Analog-Digital-Wandlers 7 und des Analog-Digital-Wandlers 8 sind mit jeweils einem Eingang einer Schnittstelle 9 gekoppelt, die wiederum mit ihrem Ausgang über einen Datenbus (Can-Bus oder dergleichen) mit einer Batterie-Management-Control ("BMC") 10 gekoppelt ist.

Die Funktionsweise des Strommessers 1 ist wie folgt:
Der als Stromsensor ausgebildete Shunt-Widerstand 3 misst den in der Leitung 2 fließenden Strom, gibt den analogen Stromwert an den Differenzverstärker 4, der den Stromwert verstärkt und von dessen Ausgang der Stromwert an den Analog-Digital-Wandler 7 und den analogen Eingang des Abtast-Halte-Glieds 6 übertragen wird. Außerdem geht der Stromwert von dem Differenzverstärker 4 an den zugeordneten Analog-Digitalwandler 7, der den empfangenen Stromwert in einen digitalen Stromwert umwandelt und über die Schnittstelle 9 an die BMC 10 überträgt.

Gleichzeitig ermittelt der als messtechnische Nulldurchgangsschaltung ausgebildete Vergleicher 5 einen Nulldurchgang des in der Leitung 2 fließenden Stromes und übermittelt ein entsprechendes (Steuer-)Signal an den digitalen Steuereingang des Abtast-Halte-Glieds 6, das in Reaktion auf das vom Vergleicher 5 erhaltene Signal den vom Shunt-Widerstand 3 bzw. Differenzverstärker 4 erhaltenen Stromwert als "Korrektur-Stromwert" speichert. Außerdem überträgt das Abtast-Halte-Glied 6 den gespeicherten Stromwert (oben auch als Korrektur-Stromwert bezeichnet) an den zugeordneten Analog-Digital-Wandler 8, der den gespeicherten Stromwert in einen digitalen Stromwert umwandelt und über die Schnittstelle 9 an die BMC 10 überträgt.

Die BMC 10 korrigiert die empfangenen Stromwerte auf Grundlage des in dem Abtast-Halte-Glied 6 gespeicherten bzw. entsprechend empfangenen digitalen Stromwerts, indem es z.B. von aktuellen Stromwerten, die von dem Shunt-Widerstand 3 gemessen werden, den entsprechenden beim Nulldurchgang ermittelten Korrektur-Stromwert abzieht.

Ein zweites Ausführungsbeispiel eines Strommessers 20 ist in Fig. 2 veranschaulicht. Der Strommesser 20 hat im Gegensatz zum ersten Ausführungsbeispiel einen Hall-Sensor 22 als Stromsensor, der in einer Leitung 21 eines Bordnetzes eines Kraftfahrzeugs angeordnet ist.

Der Ausgang des Hall-Sensors 22 ist mit einem Eingang eines Analog-Digital-Wandlers 26 gekoppelt und parallel dazu mit einem (analogen) Eingang eines Abtast-Halte-Glieds 25.

Außerdem ist der Ausgang eines Vergleichers 23, der über einen symbolisch dargestellten Widerstand 24 den Nulldurchgang des Stromes in der Leitung 21 ermittelt, ebenfalls mit einem (digitalen Steuer-)Eingang des Abtast-Halte-Glieds 25 gekoppelt.

Ein Ausgang des Abtast-Halte-Glieds 25 ist mit einem Eingang eines weiteren Analog-Digital-Wandlers 27 gekoppelt.

Der jeweilige Ausgang des Analog-Digital-Wandlers 26 und des Analog-Digital-Wandlers 27 ist mit jeweils einem Eingang einer Schnittstelle 28 gekoppelt, die wiederum mit ihrem Ausgang über einen Datenbus (Can-Bus oder dergleichen) mit einer Batterie-Management-Control ("BMC") 29 gekoppelt ist.

Die Funktionsweise des Strommessers 20 ist analog zu der des Strommessers 1 des ersten Ausführungsbeispiels und ist wie folgt:
Der als Stromsensor ausgebildete Hall-Sensor 22 misst den in der Leitung 21 fließenden Strom, gibt den analogen Stromwert an den Digital-Wandler 26 und den analogen Eingang des Abtast-Halte-Glieds 25. Der zugeordnete Analog-Digital-Wandler 26, der den empfangenen Stromwert in einen digitalen Stromwert umwandelt, überträgt den digitalen Stromwert über die Schnittstelle 28 an die BMC 29.

Gleichzeitig ermittelt der als messtechnische Nulldurchgangsschaltung ausgebildete Vergleicher 23 einen Nulldurchgang des in der Leitung 21 fließenden Stromes und übermittelt ein entsprechendes (Steuer-)Signal an den digitalen Steuereingang des Abtast-Halte-Glieds 25, das in Reaktion auf das vom Vergleicher 23 erhaltene Signal den vom Hall-Sensor 22 erhaltenen Stromwert als "Korrektur-Stromwert" speichert. Außerdem überträgt das Abtast-Halte-Glied 25 den gespeicherten Stromwert (oben auch als Korrektur-Stromwert bezeichnet) an den zugeordneten Analog-Digital-Wandler 27, der den gespeicherten Stromwert in einen digitalen Stromwert umwandelt und über die Schnittstelle 28 an die BMC 29 überträgt.

Die BMC 29 korrigiert, wie oben ausgeführt, die empfangenen Stromwerte auf Grundlage des in dem Abtast-Halte-Glied 25 gespeicherten bzw. empfangenen digitalen Stromwerts, indem es z.B. von aktuellen Stromwerten, die von dem Hall-Sensor 22 gemessen werden, den entsprechenden beim Nulldurchgang ermittelten Korrektur-Stromwert abzieht.

Ein drittes Ausführungsbeispiel eines Strommessers 30 ist in Fig. 3 veranschaulicht. Der Strommesser 30 hat einen Shunt-Widerstand 32, der in einer Leitung 31 eines Bordnetzes eines Kraftfahrzeugs angeordnet ist. Außerdem hat der Strommesser 30 im Gegensatz zum Strommesser 1 des ersten Ausführungsbeispiels einen Vergleicher 34 mit einer definierten Hysterese.

Die beiden Ausgänge des Shunt-Widerstandes 32 sind mit einem jeweiligen Eingang eines Differenzverstärkers 33 gekoppelt. Außerdem sind die beiden Ausgänge des Shunt-Widerstandes 32 parallel mit einem jeweiligen Eingang des Vergleichers 34 mit definierter Hysterese gekoppelt. Der Vergleicher 34 reagiert auf einen Nulldurchgang von Plus nach Minus anders also von Minus nach Plus, sodass er entsprechend unterschiedliche Signale ausgibt. Der vorliegende Vergleicher 34 hat eine symmetrische Hysterese, sodass die Abweichung von einem normalen Verlauf ohne Hysterese, für die beiden unterschiedlichen Nulldurchgänge (im Wesentlichen) identisch ist.

Der Vergleicher 34 ist mit dem jeweiligen (digitalen Steuer-)Eingang zweier Abtast-Halte-Glieder gekoppelt, dem digitalen Steuereingang eines ersten Abtast-Halte-Glieds 35 und parallel dazu mit dem digitalen Steuereingang eines zweiten Abtast-Halte-Glieds 36, die parallel zueinander mit dem Vergleicher 34 gekoppelt sind. Ohne dass die vorliegende Erfindung in dieser Hinsicht beschränkt sein soll, sendet der Vergleicher 34 ein erstes Signal mit steigender Flanke an das erste Abtast-Halte-Glied 35, bei einem Nulldurchgang von Minus nach Plus des Stromes in der Leitung 31, und ein zweites Signal mit fallender Flanke an das zweite Abtast-Halte-Glied 36 bei einem Nulldurchgang von Plus nach Minus. Dadurch, dass der Vergleicher 34 entsprechend ein erstes Signal mit steigender und ein zweites Signal mit fallender Flanke ausgibt, können das erste Abtast-Halte-Glied 35 und das zweite Abtast-Halte-Glied 36 derart vorgesehen sein, dass sie auf das jeweils für sie vorgesehen Signal differenziert reagieren, d.h. das Abtast-Halte-Glied 35 reagiert auf eine steigende Flanke und das Abtast-Halte-Glied 36 auf eine fallende Flanke des vom Vergleicher 34 empfangene Signals.

Der Ausgang des Differenzverstärkers 33 ist ebenfalls jeweils mit je einem Eingang des ersten bzw. zweiten Abtast-Halte-Glieds 35 bzw. 36 gekoppelt und außerdem mit dem Eingang eines Analog-Digital-Wandlers 37.

Jeweils ein Ausgang des ersten 35 bzw. zweiten 36 Abtast-Halte-Glieds ist jeweils mit einem Eingang eines zugehörigen ersten Analog-Digital-Wandlers 38 für das erste Abtast-Halte-Glied 35 und mit dem Eingang eines zugehörigen zweiten Analog-Digital-Wandlers 39 für das zweite Abtast-Halte-Glied 36 gekoppelt.

Der jeweilige Ausgang des Analog-Digital-Wandlers 37, der mit dem Differenzverstärker 33 gekoppelt ist, und des ersten 38 bzw. zweiten 39 Analog-Digital-Wandlers des ersten 35 bzw. zweiten 36 Abtast-Halte-Glieds sind mit jeweils einem Eingang einer Schnittstelle 40 gekoppelt, die wiederum mit ihrem Ausgang über einen Datenbus (Can-Bus oder dergleichen) mit einer Batterie-Management-Control ("BMC") 41 gekoppelt ist.

Die Funktionsweise des Strommessers 30 ist im Wesentlichen analog zu der des Strommessers 1 des ersten Ausführungsbeispiels und ist wie folgt:
Der als Stromsensor ausgebildete Shunt-Widerstand 32 misst den in der Leitung 31 fließenden Strom, gibt den analogen Stromwert an den Differenzverstärker 33, der den Stromwert verstärkt und von dessen Ausgang der Stromwert an den Analog-Digital-Wandler 37 und d den jeweiligen analogen Eingang des ersten 35 und des zweiten 36 Abtast-Halte-Glieds übertragen wird. Außerdem wandelt der zugeordneten Analog-Digital-Wandler 37 den empfangenen Stromwert in einen digitalen Stromwert um und überträgt den digitalen Stromwert über die Schnittstelle 40 an die BMC 41.

Gleichzeitig ermittelt der als messtechnische Nulldurchgangsschaltung ausgebildete Vergleicher 34 mit definierter Hysterese einen Nulldurchgang von Plus nach Minus oder Minus nach Plus des in der Leitung 2 fließenden Stromes und übermittelt ein entsprechendes Steuersignal, wie oben angedeutet, an den digitalen Eingang des ersten Abtast-Halte-Glieds 35, das in Reaktion auf das vom Vergleicher 34 erhaltene Signal mit steigender Flanke den vom Shunt-Widerstand 32 bzw. Differenzverstärker 33 erhaltenen Stromwert als "Korrektur-Stromwert" speichert, oder an den digitalen Eingang des zweiten Abtast-Halte-Glieds 36, das analog zum ersten Abtast-Halte-Glied 35 in Reaktion auf das Signal mit fallender Flanke den empfangenen Stromwert speichert.

Außerdem überträgt das erste Abtast-Halte-Glied 35 den gespeicherten Stromwert (oben auch als Korrektur-Stromwert bezeichnet) an den zugeordneten ersten Analog-Digital-Wandler 38 bzw. das zweite Abtast-Halte-Glied 36 überträgt den gespeicherten Stromwert (Korrektur-Stromwert) an den zweiten Analog-Digital-Wandler 39. Der erste 38 bzw. zweite Analog-Digital-Wandler 39 wandelt den gespeicherten Stromwert in einen digitalen Stromwert um und überträgt den digitalen Stromwert jeweils über die Schnittstelle 40 an die BMC 41.

Die BMC 41 empfängt jeweils von dem ersten 35 bzw. zweiten 36 Abtast-Halte-Glied einen zugehörigen ersten bzw. zweiten (digitalen) Stromwert und ermittelt einen allgemeinen Korrektur-Stromwert, indem sie bspw. den Mittelwert zwischen dem ersten und dem zweiten Stromwert bestimmt. Diesen (mittleren) Korrektur-Stromwert verwendet die BMC 41 um aktuelle empfangene Stromwerte entsprechend zu korrigieren, indem sie bspw. von dem aktuellen Stromwert den (mittleren) Korrektur-Stromwert abzieht.

Auch wenn bei den obigen drei Ausführungsbeispielen die Stromwertkorrektur in der BMC stattfindet, die dadurch auch (wenigstens teilweise) Bestandteil des jeweiligen Strommessers ist, ist die vorliegende Erfindung nicht in dieser Hinsicht beschränkt. Zum Beispiel kann ein Mikroprozessor direkt und auch örtlich nahe zu den Stromsensor, Vergleicher, Abtast-HalteGliedern und Analog-Digital-Wandler oder dergleichen angeordnet sein und die Korrektur vornehmen und bspw. einen korrigierten Stromwert über eine jeweilige Schnittstelle an eine BMC übertragen.

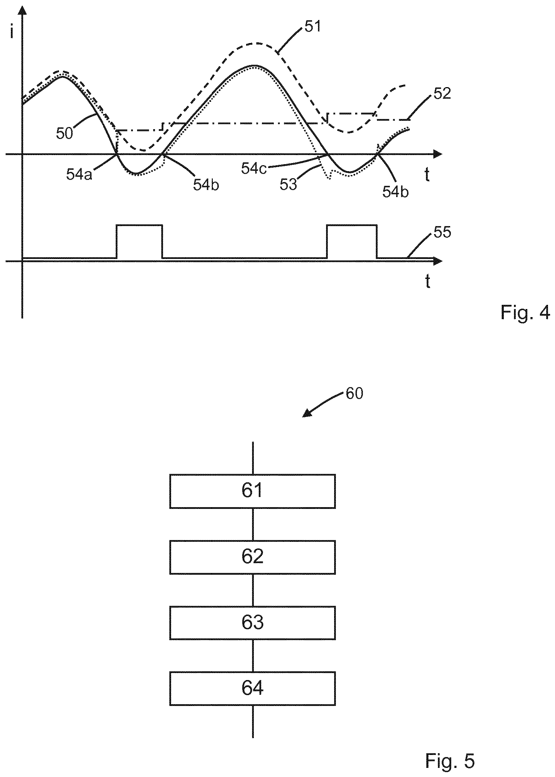

Fig. 4 veranschaulicht die Wirkung der Stromkorrektur. Fig. 4 ist ein Diagramm, das auf der Ordinate einen Stromwert i darstellt und auf der Abszisse die Zeit t. Außerdem zeigt Fig. 4 in einem unteren Teil eine Nulldurchgangskurve 55, die veranschaulicht, wenn der Stromwert null bzw. negativ wird.

Ein Ist-Stromverlauf 50, der Ist-Stromwerte repräsentiert, ist als durchgezogene Linie dargestellt und, wie aus Fig. 4 entnehmbar ist, hat der Ist-Stromverlauf 50 zwei negative Peaks mit negativen Stromwerten und hat dementsprechend vier Nulldurchgänge die mit den Bezugszeichen 54a, 54b, 54c und 54d gekennzeichnet sind. Der Ist-Stromverlauf 50 entspricht bspw. einem Stromverlauf in der Leitung 2 der Fig. 1.

Ein Mess-Stromverlauf 51, der Messwerte des Stroms repräsentiert, ist als einfach strichlierte Linie dargestellt und entspricht bspw. einer Messkurve wie sie einer der oben genannten Stromsensoren erzeugt und ausgibt, wenn keine Korrektur angewendet wird. Wie aus Fig. 4 entnehmbar ist, liegt der Mess-Stromverlauf 51 oberhalb des Ist-Stromverlaufs 50 und der Abstand variiert, das heißt die gemessenen Stromwerte liegen systematisch mit einem gewissen Abstand oberhalb der tatsächlichen Ist-Stromwerte. Dieser Abstand, der einem Messfehler entspricht und auch als Offset bezeichnet wird, ist als Offset-Stromverlauf 52 mit einer gepunktet-gestrichelten Linie dargestellt und verändert sich mit der Zeit.

Der Offset-Stromverlauf 52 repräsentiert jeweilige Korrektur-Strommesswerte, die (wie oben ausgeführt) bei einem Nulldurchgang des Ist-Stromverlaufs 50 ermittelt werden und die sich bspw. aus entsprechenden Stromwerten, wie sie im Abtast-Halteglied 6 der Fig. 1 gespeichert sind, ergeben. Daher hat der Offset-Stromverlauf 52 im Wesentlichen konstante Werte, die sich nur bei einem Nulldurchgang verändern und bspw. ansteigen oder abfallen.

Ein korrigierter Stromverlauf 53, der als gepunktete Linie dargestellt ist, repräsentiert Mess-Stromwerte des Mess-Stromverlaufs 51, die mit den jeweiligen Korrektur-Stromwerten des Offset-Stromverlaufs 52 korrigiert wurden.

Wie man Fig. 4 entnehmen kann, ist der Abstand zwischen dem korrigierten Stromverlauf 53 und dem Ist-Stromverlauf 50 wesentlich geringer als zwischen dem Mess-Stromverlauf 51 und dem Ist-Stromverlauf 50. Bei den Nulldurchgängen 54a-d sind kleine "Überschwinger" im korrigierten Stromverlauf 53 gezeigt, die durch weitere Maßnahmen (Filter oder dergleichen) geglättet werden können.

Fig. 5 zeigt ein Ablaufschema eines Verfahrens 60 zur Messung eines Stromes in einer Leitung (z.B. 2, 21, 31) in einem Bordnetz eines Kraftfahrzeugs, das z.B. durch einen der Strommesser 1, 20 oder 30 der Fig. 1 bis 3 ausgeführt werden kann bzw. auch in der BMC implementiert und von ihr ausgeführt werden kann.

Bei 61 wird ein Strom in der Leitung des Bordnetzes gemessen, bspw. mittels einem der oben beschriebenen Stromsensoren.

Bei 62 wird ein Nulldurchgang des Stromes gemessen, bspw. mittels einer der oben genannten Nulldurchgangsschaltungen.

Bei 63 wird der bei dem Nulldurchgang gemessene Strom ermittelt.

Bei 64 wird die Strommessung (das heißte künftige und/oder die aktuelle Messung des Stroms) auf Grundlage des bei dem Nulldurchgang gemessenen Stromes korrigiert. Wie oben ausgeführt, kann die Korrektur der Strommessung durch Abziehen des beim Nulldurchgang ermittelten Stromwertes von einem aktuellen Stromwert erfolgen.

Das Verfahren 60 kann kontinuierlich ablaufen, in vorgegebenen Zeitabständen ablaufen oder bspw. in Abhängigkeit eines Ereignisses (Motorstart, Zündung ein, etc.) ausgeführt werden.

### Bezugszeichenliste

- 1: Strommesser
- 2: Leitung
- 3: Shunt-Widerstand (Stromsensor)
- 4: Differenzverstärker
- 5: Vergleicher (messtechnische Nulldurchgangsschaltung)
- 6: Abtast-Halte-Glied
- 7,8: Analog-Digital-Wandler
- 9: Schnittstelle
- 10: Batterie-Management-Control
- 20: Strommesser
- 21: Leitung
- 22: Hall-Sensor (Stromsensor)
- 23: Vergleicher (messtechnische Nulldurchgangsschaltung)
- 24: Messwiderstand für 23
- 25: Abtast-Halte-Glied
- 26, 27: Analog-Digital-Wandler
- 28: Schnittstelle
- 29: Batterie-Management-Control
- 30: Strommesser
- 31: Leitung
- 32: Shunt-Widerstand (Stromsensor)
- 33: Differenzverstärker
- 34: Vergleicher (messtechnische Nulldurchgangsschaltung)
- 35, 36: Abtast-Halte-Glied
- 37: Analog-Digital-Wandler
- 38, 39: Analog-Digital-Wandler
- 40: Schnittstelle
- 41: Batterie-Management-Control
- 50: Ist-Stromverlauf
- 51: Mess-Stromverlauf
- 52: Offset-Stromverlauf
- 53: korrigierter Stromverlauf
- 54a-d: Nulldurchgänge
- 55: Nulldurchgangskurve
- 60: Verfahren zur Messung eines Stromes
- 61: Messen des Stromes
- 62: Messen eines Nulldurchgangs
- 63: Ermitteln des Stromwerts beim Nulldurchgang
- 64: Korrigieren der Strommessung

## Patentansprüche

1. Kraftfahrzeug-Bordnetz mit einem Strommesser (1) zur Messung eines Stromes in einer Leitung (2, 21, 31) des Bordnetzes, umfassend:
- einen Stromsensor (3, 22, 32), der einen Shunt-Widerstand (3, 32) oder einen Hall-Sensor (22) oder einen magnetoresistiven Sensor aufweist, zum Messen eines Stromes in der Leitung (2, 21, 31) des Bordnetzes und zum Ausgeben eines Stromwerts; und
- eine messtechnische Nulldurchgangsschaltung (5, 23, 34), die einen Vergleicher (5, 23, 34) aufweist, zum Ermitteln eines Nulldurchgangs (54a, 54b, 54c, 54d) des Stromes in der Leitung (2, 21, 32), wobei:
die Nulldurchgangsbestimmung parallel zur Strommessung erfolgt,
der Strommesser (1) dazu eingerichtet ist, einen zum Zeitpunkt des ermittelten Nulldurchgangs (54a, 54b, 54c, 54d) ermittelten Stromwert zu bestimmen,
der Strommesser (1) dazu eingerichtet ist, die vom Stromsensor (3, 22, 32) ausgegebenen Stromwerte auf Grundlage des zum Zeitpunkt des ermittelten Nulldurchgangs (54a, 54b, 54c, 54d) ermittelten Stromwerts zu korrigieren.

2. Bordnetz nach Anspruch 1, weiter einen Stromwertspeicher (6, 25, 35, 36) zum Speichern des zum Zeitpunkt des Nulldurchgangs (54a, 54b, 54c, 54d) ermittelten Stromwerts umfassend.

3. Bordnetz nach Anspruch 2, wobei der Stromwertspeicher ein Abtast-Halte-Glied (6, 25, 35, 36) aufweist.

4. Bordnetz nach einem der Ansprüche 1 bis 3, wobei der Vergleicher (34) eine definierte Hysterese aufweist.

5. Verfahren zur Messung eines Stromes in einer Leitung (2, 21, 31) in einem Bordnetz eines Kraftfahrzeugs, umfassend die Schritte:
- Messen (61) eines Stromes in der Leitung (2, 21, 31) des Bordnetzes mit einem Stromsensor (3, 22, 32), der einen Shunt-Widerstand (3, 32) oder einen Hall-Sensor oder einen magnetoresistiven Sensor aufweist;
- Messen (62) eines Nulldurchgangs (54a, 54b, 54c, 54d) des Stromes mit einer messtechnischen Nulldurchgangsschaltung, die einen Vergleicher aufweist;
- Ermitteln (63) des bei dem Nulldurchgang (54a, 54b, 54c, 54d) gemessenen Stromes, wobei die Nulldurchgangsbestimmung parallel zur Strommessung erfolgt; und
- Korrigieren (64) der Strommessung auf Grundlage des bei dem Nulldurchgang (54a, 54b, 54c, 54d) gemessenen Stromes.

## Claims

1. Motor vehicle on-board electrical system comprising an ammeter (1) for measuring a current in a line (2, 21, 31) of the on-board electrical system, comprising:
- a current sensor (3, 22, 32), which has a shunt resistor (3, 32) or a Hall sensor (22) or a magnetoresistive sensor, for measuring a current in the line (2, 21, 31) of the on-board electrical system and for outputting a current value; and
- a metrological zero-crossing circuit (5, 23, 34), which has a comparator (5, 23, 34), for ascertaining a zero crossing (54a, 54b, 54c, 54d) of the current in the line (2, 21, 32), wherein:
the zero-crossing determination is carried out in parallel with the current measurement,
the ammeter (1) is configured to determine a current value ascertained at the time of the ascertained zero crossing (54a, 54b, 54c, 54d),
the ammeter (1) is configured to correct the current values output by the current sensor (3, 22, 32) on the basis of the current value ascertained at the time of the ascertained zero crossing (54a, 54b, 54c, 54d).

2. On-board electrical system according to Claim 1, also comprising a current value storage unit (6, 25, 35, 36) for storing the current value ascertained at the time of the zero crossing (54a, 54b, 54c, 54d).

3. On-board electrical system according to Claim 2, wherein the current value storage unit has a sample-and-hold element (6, 25, 35, 36).

4. On-board electrical system according to one of Claims 1 to 3, wherein the comparator (34) has a defined hysteresis.

5. Method for measuring a current in a line (2, 21, 31) in an on-board electrical system of a motor vehicle, comprising the steps of:
- measuring (61) a current in the line (2, 21, 31) of the on-board electrical system using a current sensor (3, 22, 32) that has a shunt resistor (3, 32) or a Hall sensor or a magnetoresistive sensor;
- measuring (62) a zero crossing (54a, 54b, 54c, 54d) of the current using a metrological zero-crossing circuit, which has a comparator;
- ascertaining (63) the current measured at the zero crossing (54a, 54b, 54c, 54d), wherein the zero-crossing determination is carried out in parallel with the current measurement; and
- correcting (64) the current measurement on the basis of the current measured at the zero crossing (54a, 54b, 54c, 54d).

## Revendications

1. Réseau de bord pour véhicules automobiles, comprenant un ampèremètre (1) pour mesurer un courant dans un conducteur (2, 21, 31) du réseau de bord, comprenant :
- un capteur de courant (3, 22, 32) qui présente une résistance en dérivation (3, 32) ou un capteur à effet Hall (22) ou un capteur magnétorésistif pour mesurer un courant dans le conducteur (2, 21, 31) du réseau de bord et pour sortir une valeur de courant ; et
- un circuit de passage par zéro métrologique (5, 23, 34) qui présente un comparateur (5, 23, 34) pour établir un passage par zéro (54a, 54b, 54c, 54d) du courant dans le conducteur (2, 21, 32), dans lequel :
la détermination du passage par zéro est effectuée en parallèle à la mesure de courant,
l'ampèremètre (1) est conçu pour déterminer une valeur de courant établie au moment du passage par zéro établi (54a, 54b, 54c, 54d),
l'ampèremètre (1) est conçu pour corriger les valeurs de courant sorties par le capteur de courant (3, 22, 32) sur la base de la valeur de courant établie au moment du passage par zéro établi (54a, 54b, 54c, 54d).

2. Réseau de bord selon la revendication 1, comprenant en outre une mémoire de valeurs de courant (6, 25, 35, 36) pour mémoriser la valeur de courant établie au moment du passage par zéro (54a, 54b, 54c, 54d).

3. Réseau de bord selon la revendication 2, dans lequel la mémoire de valeurs de courant présente un circuit d'interrogation et de maintien (6, 25, 35, 36).

4. Réseau de bord selon l'une quelconque des revendications 1 à 3, dans lequel le comparateur (34) présente une hystérèse définie.

5. Procédé permettant de mesurer un courant dans un conducteur (2, 21, 31) dans un réseau de bord d'un véhicule automobile, comprenant les étapes consistant à :
- mesurer (61) un courant dans le conducteur (2, 21, 31) du réseau de bord à l'aide d'un capteur de courant (3, 22, 32) qui présente une résistance en dérivation (3, 32) ou un capteur à effet Hall ou un capteur magnétorésistif ;
- mesurer (62) un passage par zéro (54a, 54b, 54c, 54d) du courant à l'aide d'un circuit de passage par zéro métrologique qui présente un comparateur ;
- établir (63) le courant mesuré lors du passage par zéro (54a, 54b, 54c, 54d), dans lequel la détermination du passage par zéro est effectuée en parallèle à la mesure de courant ; et
- corriger (64) la mesure de courant sur la base du courant mesuré lors du passage par zéro (54a, 54b, 54c, 54d).
